# FASCICULE DE BREVET EUROPEEN

(11) **EP 0 780 486 B1**
(45) Date de publication et mention de la délivrance du brevet: **22.12.2004**
(21) Numéro de dépôt: 96203211.6
(22) Date de dépôt: 19.11.1996
(51) Int. Cl.: C23C 14/34, C23C 14/22

(54) **Procédé et dispositif pour la formation d'un revêtement sur un substrat**
Verfahren und Vorrichtung zum Beschichten eines Substrats
Process and apparatus for coating a substrate

(30) Priorité: 20.12.1995 BE 9501052
(43) Date de publication de la demande: 25.06.1997
(73) Titulaire: RECHERCHE ET DEVELOPPEMENT DU GROUPE COCKERILL SAMBRE, en abrégé: RD-CS, 4000 Liège (BE)
(72) Inventeur: Vanden Brande, Pierre, 1040 Bruxelles (BE); Lucas, Stéphane, 5020 Suarlee (BE); Weymeersch, Alain, 1300 Wavre (BE)
(74) Mandataire: Claeys, Pierre

(56) Documents cités:
- EP-A- 0 539 954
- EP-A- 0 685 571
- DE-A- 2 528 108
- US-A- 3 799 862
- IBM TECHNICAL DISCLOSURE BULLETIN, vol. 14, no. 3, Août 1971, NEW YORK, US, page 777 XP002009707 ANONYMOUS: "Niobium Bismuth Mestastable Alloys. August 1971."
- PATENT ABSTRACTS OF JAPAN vol. 014, no. 149 (C-0705), 22 Mars 1990 & JP 02 019466 A (MATSUSHITA ELECTRIC IND CO LTD), 23 Janvier 1990,
- JOURNAL OF VACUUM SCIENCE AND TECHNOLOGY, vol. 7, no. 6, 1970, pages S40-S44, US

## Description

La présente invention est relative à un procédé de formation d'un revêtement à base d'un élément, notamment d'un métal, sur un substrat dans une enceinte comportant une cible présentant une couche superficielle orientée vers le substrat et contenant l'élément, ce procédé comprenant :
- un maintien de la cible à un potentiel négatif par rapport au substrat, une création d'un plasma entre ladite couche superficielle et le substrat, dans un champ magnétique, et une amenée de la cible à une température suffisante pour permettre que ledit élément ait une tension de vapeur dans l'enceinte qui donne lieu à un passage à un état vapeur,
- un passage à un état vapeur d'une première quantité dudit élément de lacouche superficielle pour former une vapeur et une condensation de cette vapeur sur le substrat,
- simultanément au passage à un état vapeur et à la condensation, une pulvérisation cathodique de la couche superficielle de la cible pour déposer sur le substrat une deuxième quantité de l'élément susdit,
- un réglage de densité de puissance dissipée à la cible, et
- un transfert thermique entre la cible et un système de refroidissement,
(voir par exemple US-A-3.799.862 et R.C. Krutenat et W.R. Gesick, Vapor Deposition by Liquid Phase Sputtering, The Journal of Vacuum Science and Technology, vol. 7, nº6, 1970, 540 à 544).).

La présente invention propose plus particulièrement un procédé pour la formation d'un revêtement sur un substrat par condensation d'un élément sur ce substrat se déplaçant à travers une enceinte où a lieu l'évaporation dudit élément.

Les procédés connus jusqu'à présent du type précité présentent notamment l'inconvénient que, dans certains cas, surtout pour des épaisseurs de revêtement relativement importantes, des problèmes d'adhérence peuvent se poser.

De plus, l'homogénéité du revêtement tant du point de vue composition que du point de vue épaisseur n'est pas toujours constante.

Un des buts essentiels de la présente invention est de remédie à ces inconvénients et d'assurer ainsi une très bonne adhérence du revêtement au substrat même pour des épaisseurs relativement importantes tout en assurant des vitesses de dépôt et, par conséquent, un rendement élevé.

Pour résoudre ce problème, on prévoit, suivant l'invention, un procédé tel que décrit au début, ce procédé comprenant en outre
- un déplacement continu du substrat à travers l'enceinte, avec formation continue dudit revêtement sur ce substrat en mouvement,
- un contrôle d'un rapport entre ladite première quantité et ladite deuxième quantité dudit élément pendant la formation du revêtement sur le substrat en faisant varier la conductibilité thermique entre la cible et le système de refroidissement et la dissipation de densité de puissance à la cible.

D'autres modes de réalisation du procédé suivant l'invention sont indiqués dans les revendications annexées.

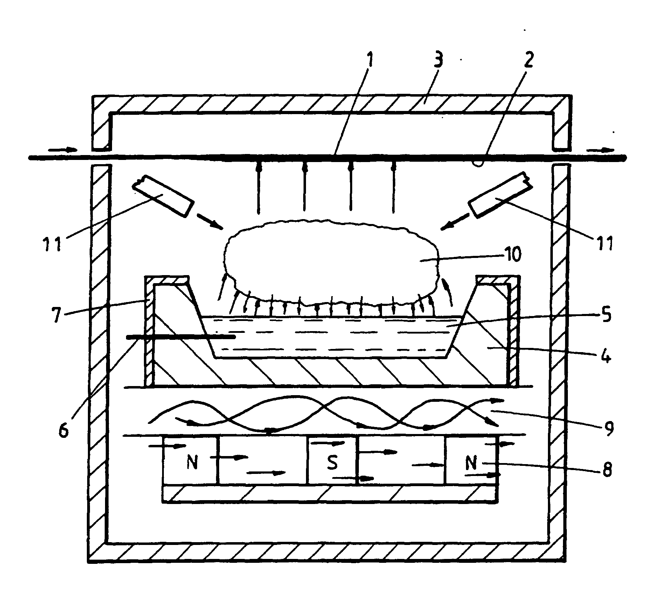

D'autres détails et particularités de l'invention ressortiront de la description donnée ci-après, à titre d'exemple, non limitatif d'une forme de réalisation particulière de l'invention avec référence à la figure unique annexée qui représente schématiquement une coupe verticale et longitudinale d'un dispositif spécifique pour la mise en oeuvre du procédé de l'invention.

L'invention concerne, d'une façon générale, un procédé, de préférence continu, pour la formation d'un revêtement sur un substrat quelconque, qui consiste en la combinaison de la technique de l'évaporation et condensation sous vide, connue en soi, et la technique de pulvérisation cathodique, encore appelée "sputtering", également connue en soi.

Suivant l'invention, il a, en effet, été constaté qu'en appliquant simultanément ces deux techniques connues, un certain effet synergique mutuel a lieu qui a comme résultat d'éviter les inconvénients que présente chacun de ces techniques utilisées séparément.

Par le procédé suivant l'invention, il est possible de réaliser sur un substrat ou support des dépôts à très grande vitesse, de sorte qu'il peut avantageusement être réalisé en continu. De plus, on obtient des revêtements d'une parfaite homogénéité et une meilleure adhérence comparée à l'utilisation de la technique d'évaporation sous vide seule. La part de l'une ou de l'autre technique dans la formation du revêtement précité est fonction de la densité de puissance maintenue à la cible et du transfert thermique entre la cible et le système de refroidissement qui fixent la température de la cible ainsi que du type d'élément à évaporer et à pulvériser.

Aussi, suivant l'invention et comme illustré par la figure, on déplace le substrat 1 à recouvrir par un revêtement de préférence métallique 2 à travers une enceinte sous vide 3 dans laquelle a lieu l'évaporation et la pulvérisation cathodique de l'élément dont est constitué le revêtement 2.

Quoique l'invention ne soit pas limitée à la formation d'un revêtement métallique, pour la facilité de l'exposé, on fera uniquement mention, ci-après, d'un métal comme élément, dont est constitué le revêtement.

Dans la forme de réalisation spécifique montrée à la figure précitée, le substrat 1 est formé par une feuille métallique, notamment par une tôle d'acier traversant l'enceinte 3 d'une manière continue.

Cette enceinte 3 comprend une cible 4 présentant une couche superficielle 5 orientée vers le substrat 1 et contenant le métal destiné à former le revêtement 2, à l'état liquide. Cette cible 4 est, en pratique, de préférence formée par un creuset contenant le métal susdit à l'état liquide. Ce creuset 4 est réalisé en une matière pouvant résister à des températures élevées de l'ordre de 1000°C à 1300°C et qui, à ces températures élevées, n'est pas attaquée par l'élément qu'il contient. Il peut être en une matière non conductrice d'électricité, telle que de l'alumine, du nitrure de bore, etc., ou en une matière conductrice d'électricité, telle que du carbone, du molybdène, du tungstène, etc. Le choix de cette matière dépend essentiellement de ses propriétés de résistance vis-à-vis du métal à évaporer et à pulvériser.

Dans le cas où le creuset 4 est réalisé en une matière non conductrice, une amenée de courant 6 doit permettre d'alimenter en puissance le métal à évaporer. Si, par contre, le creuset est en une matière conductrice d'électricité, celui-ci peut être supporté mécaniquement par une amenée de courant. Toutefois, même dans le cas d'un creuset réalisé en une matière conductrice, il peut être préférable d'utiliser une amenée de courant 6 directement en contact avec le métal à évaporer et à pulvériser afin d'assurer un bon contact électrique, indépendamment des dilatations thermiques. Les parois latérales d'un creuset en une matière conductrice sont avantageusement isolées électriquement par un écran 7 permettant d'éviter la formation d'une décharge (plasma) sur les côtés du creuset, et ainsi la pulvérisation cathodique à ces parois latérales. Le rapport des quantités, qui sont simultanément évaporées et pulvérisées, est contrôlé en agissant sur la température de la cible en faisant varier la puissance dissipée à la cible et la conductibilité thermique entre la cible et le système de refroidissement. Ce contrôle thermique permet à l'élément, notamment le métal, contenu dans le creuset 4 d'atteindre des températures suffisantes afin que la tension de vapeur dans l'enceinte 3 donne éventuellement lieu à un processus d'évaporation sous vide. De plus, le creuset 4 est disposé au-dessus d'un circuit magnétique 8 permettant ainsi une décharge magnétron. Ce circuit 8 est de préférence alimenté en courant continu.

Le circuit 8 est refroidi par une circulation d'eau de manière à le tenir à une température de 15°C à 60°C, de préférence de l'ordre de 20°C à 40°C.

Par ailleurs, le contrôle thermique du creuset 4 est réalisé par des moyens connus en soi, tels qu'un réglage du transfert thermique par des éléments d'isolation de conductibilité thermique constante ou variable 9 agencés en dessous du creuset 4 permettant de maintenir la température du creuset 4 entre 200°C et 1500°C, suivant la nature du métal contenu dans ce dernier, par exemple de l'ordre de 1200°C dans le cas de l'étain. La température détermine la tension de vapeur et donc le temps d'évaporation du métal.

Suivant une variante de l'invention, le contrôle thermique précité peut comprendre un fluide régulateur conducteur du type décrit dans le document EP-A-0 685 571.

Pour permettre la pulvérisation cathodique, le métal liquide 5 à évaporer et à pulvériser contenu dans le creuset 4 est maintenu à un potentiel négatif par rapport au substrat 1 et un plasma 10 est créé à proximité du niveau de ce métal liquide 5 grâce à la présence du circuit magnétique 8.

Un gaz inerte, tel que de l'argon, est introduit dans l'enceinte 3 par des injecteurs 11, dirigés de préférence en oblique, vers le plasma 10 et vers le métal liquide 5 contenu dans le creuset 4.

De cette façon, ce gaz est ionisé et les ions ainsi formés bombardent la surface du métal liquide 5 en éjectant des particules de ce métal vers le substrat.

Le document EP-A-0 685 571, décrit un procédé de pulvérisation cathodique qui est applicable dans le cadre de la présente invention moyennant un réglage approprié de la température du creuset dans le sens décrit ci-dessus pour obtenir la tension de vapeur requise du métal précité au-dessus du creuset 4.

La régulation de la vitesse de dépôt de ce métal sur le substrat s'obtient, suivant l'invention, par effet conjugué du réglage de la densité de puissance et du transfert thermique.

Suivant une forme de réalisation particulière du procédé suivant l'invention, la décharge ou le plasma est maintenu dans la vapeur formée du métal au-dessus du creuset. Il a été constaté que, dans ce cas, le flux de gaz inerte projeté dans le plasma par les injecteurs 11 peut être fortement réduit ou même supprimé.

Il s'est avéré qu'une décharge stable peut être obtenue si la pression totale du gaz, comprenant la vapeur de métal et le gaz inerte, dans l'enceinte est comprise entre 0,002 et 0,5 Torr.

Le procédé suivant l'invention est essentiellement applicable avec de l'étain, de l'aluminium, du zinc, du chrome et du nickel comme métal à évaporer et à pulvériser simultanément.

Le creuset 4 peut être, par exemple, formé de graphite, d'alumine ou de molybdène.

Ci-après sont repris quelques données numériques de tests effectués au moyen d'un dispositif du type de celui montré à la figure annexée dans lequel le métal était formé d'étain.

Le substrat était formé d'une tôle d'acier de 0,25 mm dont une des faces a été recouverte d'un revêtement d'étain.

Dans ces tests, le contrôle thermique a essentiellement eu lieu au moyen d'une feuille de mica régulatrice présentant une conductivité thermique de 0,35 Wm⁻¹K⁻¹ et une épaisseur de 3 mm.

Les résultats suivants ont été obtenus :

| N° du test | P W cm⁻² | % évaporé | % pulv. | µ min⁻¹ |
|---|---|---|---|---|
| 1 | 9.4 | 0 | 100 | 2 |
| 2 | 14.1 | 0.1 | 99.9 | 3 |
| 3 | 31.1 | 84.6 | 15.4 | 43.3 |

Dans le test n° 3, la tension de vapeur P_{Sn} était de 5.10⁻³ Torr, ce qui a permis de couper le flux d'argon, utilisé comme gaz inerte à ioniser.

Dans le cas où le contact thermique est parfait :

| | | | | |
|---|---|---|---|---|
| 4 | 157 | 0 | 100 | 40.5 |

Les résultats des tests n° 1 à 3 indiquent quelle est l'influence de la densité de puissance.

La comparaison des résultats des tests n° 3 et 4 montre que la pulvérisation pure (contact thermique parfait) requiert cinq fois plus de puissance que la pulvérisation plus évaporation (3 mm de mica) pour une vitesse de dépôt équivalente de l'ordre de 4 µm/min

Si, dans le test n° 3, la tôle était refroidie, l'augmentation de la température était de 1 K, alors que pour une tôle non refroidie, cette augmentation était de 69 K.

Dans le test n° 4, l'augmentation de la température pour une tôle refroidie était de 0,15 K et pour une tôle non refroidie de 14 K.

Il est bien entendu que l'invention n'est pas limitée à la forme de réalisation décrite ci-dessus du procédé pour la formation d'un revêtement sur un substrat et du dispositif représenté à la figure annexée, mais que bien des variantes peuvent être envisagées sans sortir du cadre de la présente invention, notamment en ce qui concerne la nature du substrat à recouvrir, l'élément dont le revêtement est formé, les moyens de régulation thermique, etc.

Ainsi, au cas où l'élément précité est formé de zinc, celui-ci peut être présent à l'état solide et être chauffé à une température de l'ordre de 450 à 500°C de manière à obtenir une sublimation suffisamment importante du zinc. Le zinc peut, par exemple, se présenter sous forme de granules dans le creuset.

Par conséquent, dans le cadre de la présente invention, par "évaporation" il faut comprendre le passage à l'état de vapeur aussi bien à partir d'un élément à l'état liquide qu'à l'état solide à la cible.

## Revendications

1. Procédé de formation d'un revêtement à base d'un élément, notamment d'un métal, sur un substrat dans une enceinte comportant une cible présentant une couche superficielle orientée vers le substrat et contenant l'élément, ce procédé comprenant :
- un maintien de la cible à un potentiel négatif par rapport au substrat, une création d'un plasma entre ladite couche superficielle et le substrat, dans un champ magnétique, et une amenée de la cible à une température suffisante pour permettre que ledit élément ait une tension de vapeur dans l'enceinte qui donne lieu à un passage à un état vapeur,
- un passage à un état vapeur d'une première quantité dudit élément de la couche superficielle pour former une vapeur et une condensation de cette vapeur sur le substrat,
- simultanément au passage à un état vapeur et à la condensation, une pulvérisation cathodique de la couche superficielle de la cible pour déposer sur le substrat une deuxième quantité de l'élément susdit,
- un réglage de densité de puissance dissipée à la cible, et
- un transfert thermique entre la cible et un système de refroidissement,
**caractérisé en ce qu'**il comprend en outre
- un déplacement continu du substrat à travers l'enceinte, avec formation continue dudit revêtement sur ce substrat en mouvement, et
- un contrôle d'un rapport entre ladite première quantité et ladite deuxième quantité dudit élément pendant la formation du revêtement sur le substrat en faisant varier la conductibilité thermique entre la cible et le système de refroidissement et la dissipation de densité de puissance à la cible.

2. Procédé suivant la revendication 1, **caractérisé en ce qu'**il comprend, pour la création du plasma, une introduction d'un flux de gaz inerte dans l'enceinte et le maintien du plasma dans un gaz formé du gaz inerte et de ladite vapeur de l'élément.

3. Procédé suivant la revendication 1, **caractérisé en ce que** l'on crée un plasma dans de la vapeur formée par évaporation de l'élément à partir de la cible.

4. Procédé suivant l'une des revendications 1 et 2, **caractérisé en ce que** la cible est un creuset disposé au-dessus d'un circuit magnétique qui est refroidi, permet une décharge magnétron et est de préférence alimenté en courant continu.

5. Procédé suivant l'une quelconque des revendications 1 à 4, **caractérisé en ce que** l'on maintient une pression de gaz entre la cible et le substrat supérieure à 0,002 Torr et de tout au plus 0,5 Torr.

6. Procédé suivant l'une quelconque des revendications 1 à 5, **caractérisé en ce que** l'on applique la pulvérisation cathodique précitée sensiblement en l'absence d'un gaz inerte ionisé, tel que de l'argon.

7. Procédé suivant l'une quelconque des revendications 1 à 6, **caractérisé en ce qu'**il comprend en outre un maintien du plasma à proximité de ladite couche superficielle de la cible à l'aide d'un circuit magnétique.

8. Procédé suivant l'une quelconque des revendications 1 à 7, **caractérisé en ce que** l'élément est choisi dans le groupe formé par l'étain, l'aluminium, le zinc, le chrome et la nickel.

## Patentansprüche

1. Verfahren zur Bildung einer Beschichtung auf Basis eines Elements, insbesondere eines Metalls, auf einem Substrat in einer Kammer, welche ein Target umfaßt, das eine gegen das Substrat orientierte und das Element enthaltende Oberflächenschicht aufweist, wobei dieses Verfahren umfaßt:
- ein Halten des Targets bei einem negativen Potential in Bezug auf das Substrat, eine Bildung eines Plasmas zwischen der Oberflächenschicht und dem Substrat, in einem Magnetfeld, und ein Bringen des Targets auf eine Temperatur, die ausreicht, um es zu ermöglichen, daß das Element in der Kammer einen Dampfdruck aufweist, der einen Übergang in einen Dampfzustand veranlaßt;
- einen Übergang in einen Dampfzustand einer ersten Menge des Elements aus der Oberflächenschicht, um einen Dampf zu bilden, und eine Kondensation dieses Dampfs auf dem Substrat;
- gleichzeitig mit dem Übergang in einen Dampfzustand und der Kondensation, eine Kathodenzerstäubung der Oberflächenschicht des Targets, um auf das Substrat eine zweite Menge des vorstehend genannten Elements aufzubringen;
- eine Einstellung der Verlustleistungsdichte an dem Target; und
- einen Wärmeübergang zwischen dem Target und einem Kühlsystem;
**dadurch gekennzeichnet, daß** es ferner umfaßt:
- eine kontinuierliche Bewegung des Substrats durch die Kammer, mit kontinuierlicher Bildung der Beschichtung auf diesem sich bewegenden Substrat; und
- eine Einstellung eines Verhältnisses zwischen der ersten Menge und der zweiten Menge des Elements während der Bildung der Beschichtung auf dem Substrat, durch Variieren der Wärmeleitfähigkeit zwischen dem Target und dem Kühlsystem und Variieren der Verlustleistungsdichte an dem Target.

2. Verfahren nach Anspruch 1, **dadurch gekennzeichnet, daß** es zur Bildung des Plasmas ein Einleiten eines Inertgasstroms in die Kammer und das Aufrechterhalten des Plasmas in einem aus dem Inertgas und dem Dampf des Elements gebildeten Gas umfaßt.

3. Verfahren nach Anspruch 1, **dadurch gekennzeichnet, daß** ein Plasma in dem Dampf, der durch Verdampfung des Elements aus dem Target gebildet wird, gebildet wird.

4. Verfahren nach Anspruch 1 oder 2, **dadurch gekennzeichnet, daß** das Target ein Tiegel ist, der oberhalb eines Magnetkreises angeordnet ist, welcher gekühlt ist, eine Magnetronentladung ermöglicht und vorzugsweise mit Gleichstrom versorgt wird.

5. Verfahren nach einem der Ansprüche 1 bis 4, **dadurch gekennzeichnet, daß** zwischen dem Target und dem Substrat ein Gasdruck aufrechterhalten wird, der oberhalb von 0,002 Torr und höchstens bei 0,5 Torr liegt.

6. Verfahren nach einem der Ansprüche 1 bis 5, **dadurch gekennzeichnet, daß** die vorstehend genannte Kathodenzerstäubung im wesentlichen in Abwesenheit eines ionisierten Inertgases, wie beispielsweise Argon, durchgeführt wird.

7. Verfahren nach einem der Ansprüche 1 bis 6, **dadurch gekennzeichnet, daß** es ferner ein Aufrechterhalten des Plasmas in der Nähe der Oberflächenschicht des Targets mit Hilfe eines Magnetkreises umfaßt.

8. Verfahren nach einem der Ansprüche 1 bis 7, **dadurch gekennzeichnet, daß** das Element ausgewählt ist aus der Gruppe, die von Zinn, Aluminium, Zink, Chrom und Nickel gebildet wird.

## Claims

1. A process for the formation of a coating from an element, particularly a metal, on a substrate within an enclosure comprising a target having a surface layer directed towards the substrate and containing the element, which process comprises :
- keeping the target at a negative potential in relation to the substrate, a plasma being created between said surface layer and the substrate, within a magnetic field, the target being brought to a temperature sufficient to allow that said element has a vapour tension within the enclosure which gives rise to a transition to a vapour state,
- a transition to a vapour state of a first quantity of said element of the surface layer to form a vapour and a condensation of said vapour on the substrate,
- simultaneously to the transition to a vapour state and to the condensation, a cathodic sputtering from the surface layer of the target for depositing onto the substrate a second quantity of said element,
- a regulation of the power density dissipated to the target, and
- a thermal transfer between the target and a cooling system,
**characterized in that** it further comprises
- a continuous displacement of the substrate through the enclosure, with continuous formation of said coating onto said moving substrate, and
- a control of ratio between said first quantity and said second quantity of said element during the formation of the coating on the substrate by varying the thermal conductivity between the target and the cooling system and the power density dissipated to the target.

2. A process according to claim 1, **characterized in that**, for the creation of the plasma, it comprises introducing an inert gas flow within the enclosure and maintaining the plasma in a gas formed by the inert gas and said vapour of the element.

3. A process according to claim 1, **characterized in that** a plasma is created in the vapour formed by evaporation of the element from the target.

4. A process according to either one of claims 1 and 2, **characterized in that** the target is a crucible located above a magnetic circuit which is cooled, enables a magnetron discharge and is preferably supplied with direct current.

5. A process according to any one of claims 1 to 4, **characterized in that** a gas pressure is maintained between the target and the substrate of in excess of 0.002 Torr and at most 0.5 Torr.

6. A process according to any one of claims 1 to 5, **characterized in that** the said cathodic sputtering is carried out substantially in the absence of an ionised inert gas, such as argon.

7. A process according to any one of claims 1 to 6, **characterized in that** it furter comprises keeping the plasma in the vicinity of said surface layer of the target by means of a magnetic circuit.

8. A process according to any one of claims 1 to 7, **characterized in that** the element is selected from the group consisting of tin, aluminium, zinc, chromium and nickel.
